(19) Europäisches Patentamt
European Patent Office
Office européen des brevets

(11) **EP 1 231 476 B1**

(12) **EUROPÄISCHE PATENTSCHRIFT**

(45) Veröffentlichungstag und Bekanntmachung des Hinweises auf die Patenterteilung:
**27.02.2008 Patentblatt 2008/09**

(51) Int Cl.:
*G01R 31/36* *(2006.01)*    *H01M 10/42* *(2006.01)*

(21) Anmeldenummer: **01127008.9**

(22) Anmeldetag: **14.11.2001**

(54) **Verfahren und Anordnung zur Bestimmung des Alterungszustands einer Batterie**

Method and apparatus for determining the state of health of a battery

Méthode et appareil pour déterminer l'état d'usure d'une batterie

(84) Benannte Vertragsstaaten:
**DE FR GB SE**

(30) Priorität: **13.02.2001 DE 10106508**

(43) Veröffentlichungstag der Anmeldung:
**14.08.2002 Patentblatt 2002/33**

(73) Patentinhaber: **ROBERT BOSCH GMBH**
**70442 Stuttgart (DE)**

(72) Erfinder: **Schoch, Eberhard**
**70469 Stuttgart (DE)**

(56) Entgegenhaltungen:
**EP-A- 0 505 333**        **WO-A-89/01169**
**WO-A-90/13823**

## Beschreibung

## Technisches Gebiet

Die vorliegende Erfindung betrifft ein Verfahren und eine Anordnung zur Bestimmung der Leistungsfähigkeit einer Batterie, insbesondere einer Kraftfahrzeug-Starterbatterie.

## Stand der Technik

Beim Einsatz sicherheitskritischer elektrischer Verbraucher, wie beispielsweise break-by-wire oder stear-by-wire-Systemen sowie elektrohydraulischen Bremssystemen (EHB-Systeme) oder Start-Stop-Systemen in einem Kraftfahrzeug müssen die Energiespeicher zur Versorgung dieser Systeme ständig überwacht und insbesondere vor Eintreten einer entsprechenden Belastung auf ihre Leistungsfähigkeit geprüft werden, um einen Ausfall rechtzeitig erkennen und signalisieren bzw. Maßnahmen zur Erhöhung der Leistungsfähigkeit der Energiespeicher beispielsweise durch Erhöhung der Ladespannung und/oder Abschalten von Verbrauchern einleiten zu können.

Zur Vorhersage der Leistungsfähigkeit von Starterbatterien sind verschiedene Verfahren bekannt. In diesem Zusammenhang werden beispielsweise die für das Leistungsvermögen der Batterien maßgeblichen Größen, wie Ladezustand und Batterieinnenwiderstand beispielsweise durch Auswertung der Ruhespannung sowie Spannungs- und Strommessungen beim Start oder mittels modellbasierter Zustandsbeobachtung bei kontinuierlicher Messung von Spannung, Strom und Temperatur bestimmt, und mit Hilfe dieser Größen eine zu erwartende Leistungsabgabe der Batterie vorausberechnet. Der erstgenannte Verfahrenstyp hat den Nachteil, dass Ladezustand und Innenwiderstand nur bei bestimmten Betriebsbedingungen (Ruhephase bzw. Start) rekalibriert werden können. Zu anderen Zeitpunkten sind Extrapolationen notwendig, was zu Fehlern in der Vorhersage der Batterieleistungsfähigkeit führt, insbesondere beim sogenannten Taxibetrieb, bei welchem die Ruhephasen kaum vorhanden bzw. sehr kurz sind. Außerdem werden bei derartigen Verfahren dynamische Änderungen der Leistungsfähigkeit z. B. nach Starterbatteriebelastung, nicht berücksichtigt.

Die modellbasierten Verfahren schätzen während des Fahrzeugbetriebes kontinuierlich den Ladezustand und den Innenwiderstand sowie zusätzlich auch dynamische Spannungsabfälle in der Batterie, wodurch eine gute Vorhersage der Leistungsfähigkeit der Batterie möglich ist. Diese Verfahren erweisen sich in der Praxis jedoch als sehr aufwendig, da ein hierbei benötigtes Batteriemodell zur Abdeckung des gesamten Arbeitsbereiches der Batterie in der Regel stark nichtlinear ist und viele zu schätzende Parameter umfasst.

Ein derartiges Verfahren zur Bestimmung des Ladungszustandes und weiterer physikalischer Größen, wie Verschleißzustand, Alter, Exemplarstreuung, Vorgeschichte und Ladewirkungsgrad eines wiederaufladbaren elektrischen Energiespeichers, d. h. einer Batterie, ist aus der EP 471698 B1 bekannt. Hierbei werden Prozesseingangsgrößen des Energiespeichers gemessen und in einem Rechner verarbeitet, wobei nach dem Prinzip des indirekten Messens ein vorgebbares Modell nichtlinearer mehrparametriger Funktionen, das den Ladungszustand und die zu bestimmenden physikalischen Größen und ihre physikalischen Beziehungen zueinander repräsentiert, mit den gemessenen Prozesseingangsgrößen verglichen, wobei für die nachfolgende Messung im Falle von Abweichungen die Modellparameter adaptiert werden. Bei diesem Verfahren ist vorgesehen, dass zur Ermittlung des Ladungszustandes und der zu bestimmenden physikalischen Größen eine vielparametrige Beschreibung in Form des Modells und einer heuristrischen Parametrierung verwendet wird, wobei die Beschreibung mehr Parameter aufweist, als Prozesseingangsgrößen und die unterbestimmte Lösungsmenge des Modells zunächst und dann der Ladungszustand und die weiteren physikalischen Größen mit Hilfe der Parametrierung als Schätzung unter Verwendung von Kennlinien und Daten bekannter Energiespeicher bestimmt wird.

Aus der Druckschrift WO 90/13828 A sind Verfahren und Vorrichtungen zum Abschätzen der Leistungsfähigkeit einer Batterie bekannt, bei denen zur Bestimmung von physikalischen Größen von wiederaufladbaren Batterien die Prozesseingangsgrößen der Batterie gemessen und in einem Rechner verarbeitet werden. Mit Hilfe des Prinzips des indirekten Messens mittels eines vorgebbaren Models werden Größen, die nicht gemessen werden können, abgeschätzt. Die zu bestimmenden physikalischen Größen und die gemessenen Prozesseingangsgrößen werden miteinander verglichen, damit für die nachfolgende Messung das Modell oder die Schätzung adaptiert werden kann.

Ziel der Erfindung ist es, ein möglichst einfaches Modell zur Abschätzung eines Batterieverhaltens, insbesondere der Leistungsfähigkeit einer Batterie, bereitzustellen.

Vorteile der Erfindung

Dieses Ziel ist erreicht durch ein Verfahren mit den Merkmalen des Patentanspruchs 1 sowie eine Anordnung mit den Merkmalen des Patentanspruchs.5.

Erfindungsgemäß wird die Leistungsfähigkeit einer Batterie, insbesondere einer Kraftfahrzeug-Starterbatterie, bezüglich vorgegebener Laststromverläufe, insbesondere Laststromverläufe bestimmter Verbraucher, durch Adaption eines einfachen, für den entsprechenden Belastungsfall gültigen Modells mit einer Minimalzahl zu schätzender Parameter ermittelt. Das Modell kann als Hardware- oder Softwaremodell realisiert sein. Die Bestimmung der Batterieparameter kann während des normalen Fahrbetriebes erfolgen, und ist nicht auf lange Ruhephasen oder eine Hochstrombelastung beispielsweise während des Starts angewiesen. Somit ist auch eine schnelle Adaption der Parameter nach einem Tausch oder einem Nachladen der Batterie möglich. Neben den statischen Größen wie Ladezustand und Innenwiderstand wird auch der dynamische Spannungsabfall in der Batterie unmittelbar nach einer Lastaufschaltung ermittelt, womit insgesamt eine sehr genaue Vorhersage der Leistungsfähigkeit der Batterie möglich ist.

Vorteilhafte Ausgestaltungen des erfindungsgemäßen Verfahrens bzw. der erfindungsgemäßen Anordnung sind Gegenstand der Unteransprüche.

Vorteilhafterweise werden die im Rahmen der erfindungsgemäßen Abschätzung verwendeten Parameter Ruhespannung $U_R$, Innenwiderstand $R_I$ und innerer Spannungsabfall $U_K$ unter Verwendung einer Beobachtungseinrichtung, insbesondere eines Kalmanfilters ermittelt, welche auf der Grundlage einer gemessenen Batteriespannung und/oder einer gemessenen Batterietemperatur und/oder eines gemessenen Batteriestroms unter Verwendung eines Modells die Parameter $U_R$, $R_E$ und $U_K$ abschätzt. Auch dieses Modell kann als Hardware- oder Softwaremodell ausgeführt sein. Es ist vorteilhaft, wenn die beiden erwähnten Modelle zur Beschreibung der Batterie im wesentlichen übereinstimmen.

Zweckmäßigerweise wird bei dem Vergleich der Spannungsantwort $U_{Batt,präd}$ mit einer voreinstellbaren minimalen Batteriespannung $U_{Batt,grenz}$ der Minimalwert der Spannungsantwort $min(U_{Batt,präd})$ berücksichtigt. Mittels eines derartigen Vergleichs ist eine eindeutige Aussage möglich, ob die Batterie eine für den sicheren Betrieb des betrachteten Verbrauchers geforderte minimale Batteriespannung $U_{Batt,grenz}$ zur Verfügung stellen kann.

Zweckmäßigerweise wird die Leistungsfähigkeit der Batterie unter Verwendung einer Formel der Form

$$SOH = (min(U_{Batt,präd}(t)) - U_{Batt,grenz})/(U_{Batt,norm} - U_{Batt,grenz})$$

ermittelt, wobei $U_{Batt,norm}$ die bei der Belastung einer neuen, vollbeladenen und ausgeglichenen Batterie mit dem betrachteten Verbraucher auftretende minimale Klemmenspannung bei Raumtemperatur ist. Für eine solche Batterie ist $SOH = 1$. Durch Alterung, Entladung und Vorbelastung der Batterie sowie bei niedrigen Temperaturen dürfte der Spannungseinbruch größer und der SOH-Wert kleiner sein. Bei $SOH = 0$ wird die Minimalanforderung gerade noch erfüllt. Es sei darauf hingewiesen, dass SOH die übliche Abkürzung für den englischen Begriff "State Of Health" der Batterie darstellt.

Er erweist sich ferner als vorteilhaft, auf der Grundlage der ermittelten Ruhespannung den Ladezustand (SOC) der Batterie zu ermitteln. Hiermit ist eine weitere statische Größe zur Beschreibung des Batteriezustandes zur Verfügung gestellt. Neben den statischen Größen wie Ladezustand und Innenwiderstand ist nun, da auch der dynamische Spannungsabfall in der Batterie unmittelbar nach einer Lastaufschaltung, wie oben beschrieben, ermittelbar ist, eine sehr genaue Vorhersage der Leistungsfähigkeit der Batterie möglich.

**Zeichnung**

Bevorzugte Ausführungsformen der Erfindung werden nun anhand der beigefügten Zeichnung näher erläutert. In dieser zeigt

Figur 1    ein schematisches Blockschaltbild zur Darstellung der erfindungsgemäß vorgesehenen Abschätzung der Leistungsfähigkeit einer Batterie, und

Figur 2    ein Flussdiagramm zur Darstellung einer bevorzugten Ausführungsform des erfindungsgemäßen Verfahrens.

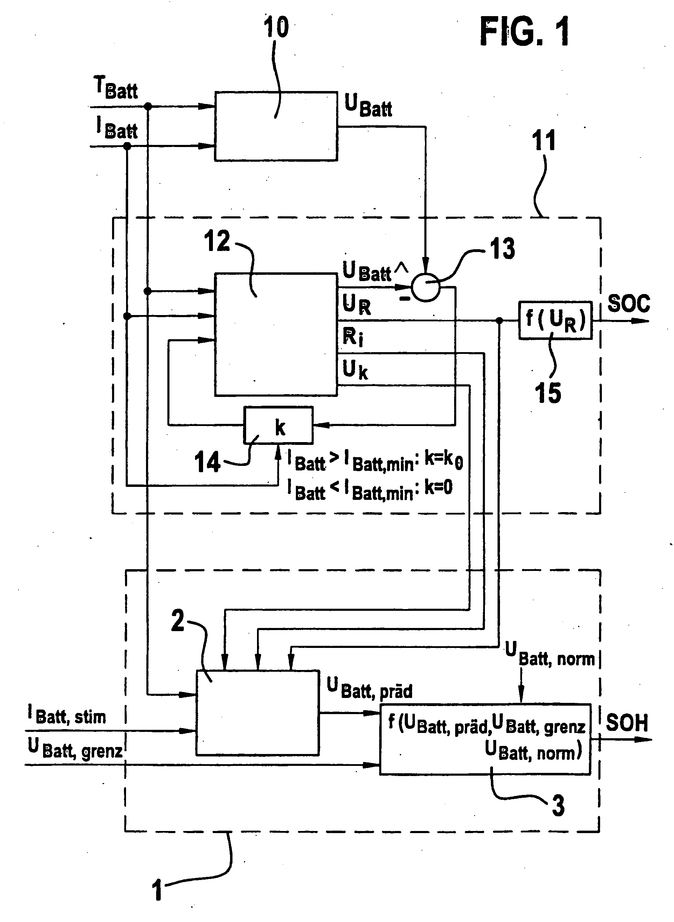

In Figur 1 ist eine Fahrzeugbatterie insgesamt mit 10 bezeichnet. Die Batterie 10 weist einen Batteriestrom $I_{Batt}$, eine Batterietemperatur $T_{Batt}$ und eine Batteriespannung $U_{Batt}$ auf, welche jeweils gemessen werden.

Die genannten Messwerte werden auf eine insgesamt mit 11 bezeichnete Beobachtungseinrichtung, beispielsweise einen Kalman-Filter gegeben. Die Beobachtungseinrichtung 11 setzt ein die Batterie 10 abbildendes Modell, hier der Einfachheit halber mit 12 bezeichnet, ein. Das Modell 12 schätzt aufgrund der Eingangsgröße $T_{Batt}$ und $I_{Batt}$ eine geschätzte Batteriespannung $U_{Batt}{}^\wedge$. Hierbei wird die Modellrechnung durch Rückkopplung des Fehlers $U_{Batt} - U_{Batt}{}^\wedge$ zwischen gemessener und berechneter Batteriespannung abgeglichen (Komparator 13).

Es ist vorteilhaft, den Modellabgleich nur bei Vorliegen von für die Modellgültigkeit relevanten Arbeitspunkten durchzuführen, beispielsweise für den Fall (wenn Entladeströme positiv gezählt werden), dass der Entladestrom der Batterie 10 > 0 ist, d. h. $I_{Batt} > I_{Batt,min}$. Für diesen Fall wird bei 14 ein Wert $k = k_0 \times (U_{Batt} - U_{Batt}{}^\wedge)$ in die Modellrechnung

als dritte Eingangsgröße neben den Messwerten $T_{Batt}$ und $I_{Batt}$ eingespeist.

In den übrigen Arbeitspunkten, für die gilt $I_{Batt} \leq I_{Batt,min}$, wird die Rückkopplung des Fehlers in die Rechnung unterbrochen, d. h. k wird gleich 0 gesetzt. Es ist möglich, in einem derartigen zweiten Arbeitsbereich die Ruhespannung $U_R$ der Batterie aus dem Stromintegral $Q = -\int I_{Batt} dt$ und der zuletzt, insbesondere während des Vorliegens des ersten Arbeitsbereiches geschätzten Ruhespannung $R_o$ gemäß der Gleichung $U_R = U_{R0} + Q/C$ zu berechnen.

Für beide Arbeitsbereiche wird der sich aus der Rechnung bzw. Abschätzung mittels der Einrichtung 11 ergebende Ruhespannungswert $U_R$ einer weiteren funktionalen Beaufschlagung zum Erhalt des Batterieladezustands SOC (englisch: State Of Charge) unterzogen. Der Batteriezustand wird zweckmäßigerweise gemäß einer Gleichung der Formel $SOC = f(U_R) = (U_R - U_{R,min}) / (U_{R,max} - U_{R,min})$ bestimmt. Die funktionale Beaufschlagung des ermittelten Ruhespannungswertes $U_R$ erfolgt bei 15.

$U_{R,min}$ bzw. $U_{R,max}$ bezeichnen hierbei die minimale bzw. maximale Ruhespannung bei den vom Batteriehersteller angegebenen Werten der Säuredichte für eine leere bzw. vollgeladene Batterie.

Man erkennt, dass mittels des Modells 12 zusätzlich zur Ruhespannung $U_R$ auch der Innenwiderstand $R_I$ und der innere Spannungsabfall $U_K$, der von Dichteunterschieden in der Batteriesäure verursacht ist, geschätzt wird. Mit diesen Abschätzungsergebnissen des Modells 12 liegen die wesentlichen Parameter zur Bestimmung der Leistungsfähigkeit der Batterie vor.

Zur Bestimmung der Leistungsfähigkeit der Batterie 10 werden die geschätzten Werte $U_R$, $R_I$ und $U_K$ einem Prädiktor, der insgesamt mit 1 bezeichnet ist, zugeführt, welcher das gleiche Modell zur Beschreibung der Batterie 10 wie das Kalman-Filter 11 enthält. Die Modelle geben das Batterieverhalten in einem betrachteten Belastungsfall ausreichend genau wieder. Das dem Modell 12 entsprechende Modell ist hier mit 2 bezeichnet.

Das Modell 2 wird mit den von dem Kalman-Filter 11 ermittelten Größen $U_R$, $R_I$ und $U_K$ initialisiert und mit einem für einen betrachteten verbrauchertypischen Laststromverlauf $I_{Batt,stim}$ (t) stimuliert. Als betrachtete Verbraucher kommen beispielsweise eine elektromagnetische Bremse (EMB), eine elektrohydraulische Bremse (EHB) oder eine Stareinrichtung in Frage.

Auf der Grundlage der Eingangsgrößen $I_{Batt,stim}$, $U_R$, $R_I$ und $U_K$ wird mit Hilfe des Modells 2 die Spannungsantwort $U_{Batt,präd}$ der Batterie bezüglich des vorgegebenen Laststromverlaufes abgeschätzt. Die Differenz aus dem Minimalwert der Spannungsantwort, $\min(U_{Batt,präd}(t))$ des Modells aufgrund der stimulierten Belastung und der für den sicheren Betrieb des betrachteten Verbrauchers geforderten minimalen Batteriespannung $U_{Batt,grenz}$ stellt ein absolutes Maß für die Leistungsfähigkeit der Batterie 10 dar.

Diese Differenzbildung $\Delta U_{Batt} = \min(U_{Batt,prad}(t)) - U_{Batt,grenz}$ wird in einem Komperator 3 des Prädiktors 1 durchgeführt.

Für den Vergleich verschiedener Batterien eignet sich das mit SOH (engl. State of Health) bezeichnete Maß besser. Hierbei wird gemäß der Formel

$$SOH = (\min(U_{Batt,präd}(t)) - U_{Batt,grenz}) / (U_{Batt,norm} - U_{Batt,grenz})$$

das Batterieleistungsfähigkeitsmaß SOH ermittelt. $U_{Batt,norm}$ ist die bei der Belastung einer neuen, vollgeladenen und ausgeglichenen Batterie mit dem betrachteten Verbraucher auftretende minimale Klemmenspannung bei Raumtemperatur. Für eine solche Batterie gilt SOH = 1. Durch Alterung, Entladung und Vorbelastung der Batterie sowie bedingt durch niedrige Temperaturen wird der von der Belastung verursachte Spannungseinbruch größer und somit der SOH-Wert kleiner. Bei SOH = 0 werden die minimalen Anforderungen an die Batterie gerade noch erfüllt.

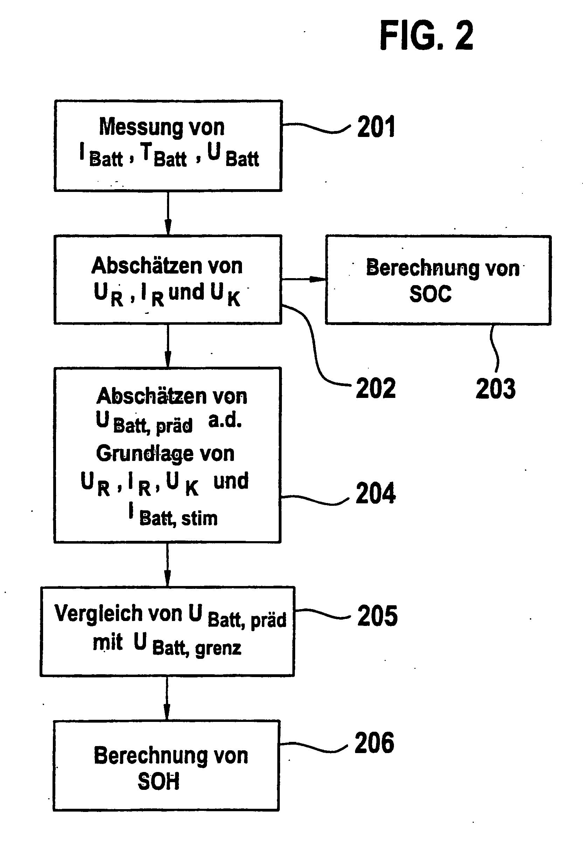

Die wesentlichen Schritte des erfindungsgemäßen Verfahrens werden nun anhand der Figur 2 erläutert.

In einem Schritt 201 erfolgt eine Messung der Batterietemperatur $T_{Batt}$, des Batteriestroms $I_{Batt}$ und der Batteriespannung $U_{Batt}$. In einem Schritt 202 werden unter Zuhilfenahme eines ein die Batterie darstellenden Modells 12 verwendenden Kalman-Filters die Ruhespannung $U_R$, der Innenwiderstand $R_I$ und der Spannungsabfall $U_K$ aufgrund von Dichteunterschieden in der Batteriesäure abgeschätzt. Ein hierbei ebenfalls abgeschätzter Batteriespannungswert $U_{Batt}{}^\wedge$ kann mit dem gemessenen Batteriespannungswert $U_{Batt}$ abgeglichen und ebenfalls in das Modell 12 als Eingangsgröße eingespeist werden. Der Ruhespannungswert $U_R$ wird vorteilhafterweise auch zur Berechnung des Ladezustands SOC der Batterie verwendet werden (Schritt 203).

In einem anschließenden Schritt 204 erfolgt in einem Prädiktor aufgrund eines Modells 2, welches vorteilhafterweise das gleiche Batteriemodell wie das Modell 12 beschreibt, die Abschätzung einer Spannungsantwort $U_{Batt,präd}$ (t) der Batterie aufgrund einer simulierten Belastung durch einen jeweils betrachteten Verbraucher. Zu diesem Zwecke wird die Modellrechnung mittels der Größen $U_R$, $R_I$ und $U_K$ initialisiert und mit dem für den betrachteten verbrauchertypischen Laststromverlauf $I_{Batt,stim}$(t) stimuliert.

In einem anschließenden Schritt 205 erfolgt ein Vergleich der Spannungsantwort $U_{Batt,präd}$(t) mit einer für den sicheren Betrieb des betrachteten Verbrauchers geforderten minimalen Batteriespannung $U_{Batt,grenz}$. Zweckmäßigerweise wird hierbei die Differenz aus dem Minimalwert der Spannungsantwort (min($U_{Batt,präd}$(t)) des Modells auf die Belastung und der für den sicheren Betrieb des betrachteten Verbrauchers geforderten minimalen Batteriespannung $U_{Batt, grenz}$ berechnet.

In einem anschließenden Schritt 206 wird auf der Grundlage des ermittelten Spannungsdifferenzwertes $\Delta U_{Batt}$ = min($U_{Batt,präd}$(t)) - $U_{Batt,grenz}$ gemäß der oben angegebenen Formel der Wert SOH als relatives Maß zur Darstellung der Batterieleistungsfähigkeit berechnet.

**Patentansprüche**

1.  Verfahren zum Abschätzen des Alterungszustands oder "State of Health SOH" einer Batterie mit folgenden Schritten:

    Abschätzung einer Ruhespannung $U_R$, eines Innenwiderstands $R_I$ und eines aufgrund von Dichteunterschieden in der Batteriesäure verursachten inneren Spannungsabfalls $U_K$ der Batterie als Eingangsgrößen eines Modells,
    Initialisierung des die Batterie beschreibenden Modells (2) zum Abschätzen des Alterungszustands oder "State of Health SOH" mit den abgeschätzten Werten $U_R$, R, und $U_K$,
    Stimulierung des initialisierten Modells mit einem vorgegebenen Laststromverlauf $I_{Batt, stim}$, insbesondere eines simulierten Laststromverlaufs eines mit der Batterie in Wirkverbindung stehenden Verbrauchers, zum Erhalt einer die Batteriespannung bei dem vorgegebenen Laststromverlauf darstellenden Spannungsantwort $U_{Batt, präd}$ des Modells (2)
    Vergleich der Spannungsantwort $U_{Batt, präd}$ des Modells (2) mit einer voreinstellbaren minimalen Batteriespannung $U_{Batt, grenz}$ und
    **gekennzeichnet durch** das Abschätzen des Alterungszustands oder "State of Health SOH" der Batterie unter Verwendung der Formel:

    $$SOH = (min(U_{Batt, präd,} (t)) - U_{Batt, grenz}) / (U_{Batt, norm} - U_{Batt, grenz})$$

    wobei bei dem Vergleich der Spannungsantwort $U_{Batt, präd}$, mit der voreinstellbaren minimalen Batteriespannung $U_{Batt, grenz}$ der über die Zeit minimale Wert der Spannungsantwort, min($U_{Batt, präd,}$) verwendet wird
    und $U_{Batt, norm}$ die bei der Belastung einer neuen voll beladenen und ausgeglichenen Batterie mit dem betrachtenden Verbraucher auftretende Klemmenspannung bei Raumtemperatur ist und min($U_{Batt,präd,}$) der über die Zeit minimale Wert der Spannungsantwort ist
    und die Eingangsgrößen mittels einer Beobachtungseinrichtung (11), insbesondere eines Kalman-Filters ermittelt werden, welcher auf der Grundlage einer gemessenen Batteriespannung $U_{batt}$, einer gemessenen Batterietemperatur $T_{Batt}$ und eines gemessenen Batteriestroms $I_{Batt}$ unter Verwendung eines die Batterie beschreibenden Modells (2) die Werte Ruhespannung $U_R$, Innenwiderstand R, und Spannungsabfall $U_K$ abschätzt.

2.  Verfahren nach dem vorstehenden Anspruch, **dadurch gekennzeichnet, dass** auf der Grundlage der abgeschätzten Ruhespannung $U_R$ der Ladezustand (SOC) der Batterie ermittelt wird.

3.  Anordnung zum Abschätzen des Atterungszustands oder "state of health SOH" einer Batterie, insbesondere einer Kraftfahrzeug-Starterbatterie, mit einem Prädiktor (1) zum Abschätzen einer bei einem bestimmten Laststromverlauf $I_{Batt,stim}$ auftretenden Batteriespannung $U_{Batt,präd}$, wobei einem von dem Prädiktor (1) verwendeten Modell (2) zur Darstellung der Batterie als Eingangsgrößen die Ruhespannung $U_R$, der Innenwiderstand $R_I$ und der aufgrund von Dichteunterschieden in der Batteriesäure verursachte innere Spannungsabfall UK sowie der bestimmte Laststromverlauf $I_{Batt,stim}$ zuführbar sind, und eine als Antwort des Modells (2) erhaltene abgeschätzte Batteriespannung $U_{Batt, präd}$, welche eine Abschätzung der Batteriespannung bezüglich des Laststromverlaufes $I_{Batt, stim}$ darstellt, zum Abschätzen des Atterungszustands oder "state of health SOH" der Batterie mit einer Grenzspannung $U_{Batt grenz}$ verglichen wird, wobei die Eingangsgrößen einer Beobachtungseinrichtung (11), insbesondere einem Kalman-Filter zuführbar sind, mittels dessen die verwendeten Parameter Ruhespannung $U_R$, Innenwiderstand $R_I$ und Spannungsabfall $U_K$ auf der Grundlage einer gemessenen Batteriespannung $U_{batt}$, einer gemessenen Batterietemperatur $T_{Batt}$ und eines gemessenen Batteriestroms $I_{Batt}$ abschätzbar sind und **gekennzeichnet durch** das Berechnen der Batterie unter Verwendung einer Formel der Form

$$SOH = (\min(U_{Batt,\ präd.}(t)) - U_{Batt,\ grenz}) / (U_{Batt,\ norm} - U_{Batt,\ grenz}),$$

wobei

$U_{Batt,\ norm}$ die bei der Belastung einer neuen voll beladenen und ausgeglichenen Batterie mit dem betrachtenden Verbraucher auftretende Klemmenspannung bei Raumtemperatur ist und $\min(U_{Battt,\ präd.})$ der über die Zeit minimale Wert der Spannungsantwort ist.

**Claims**

1. Method for estimating the state of health (SOH) of a battery, comprising the following steps:

   estimation of a rest voltage $U_R$ of an internal resistance $R_I$ and of an internal voltage drop $U_K$, caused by density differences in the battery acid, of the battery as input variables of a model,
   initialization of the model (2) which describes the battery, in order to estimate the state of health (SOH) using the estimated values $U_R$, $R_I$ and $U_K$,
   stimulation of the initialized model using a predetermined load current profile $I_{Batt,\ stim}$, in particular of a simulated load current profile of a load which is operatively connected to the battery, in order to obtain a voltage response $U_{Batt,\ pred}$, which represents the battery voltage for the predetermined load current profile, of the model (2),
   comparison of the voltage response $U_{Batt,\ pred}$ of the model (2) with a preselectable minimum battery voltage $U_{Batt,\ limit}$ and
   **characterized by**
   estimation of the state of health (SOH) of the battery using the following formula:

$$SOH = (\min(U_{Batt,\ pred,}(t)) - U_{Batt,\ limit}) / (U_{Batt,\ norm} - U_{Batt,\ limit})$$

   with the minimum value of the voltage response over time, $\min(U_{Batt,\ pred})$, being used for the comparison of the voltage response $U_{Batt,\ pred}$ with the preselectable minimum battery voltage $U_{Batt,\ limit}$
   and $U_{Batt,\ norm}$ being the terminal voltage which occurs when a new fully charged and stabilized battery is loaded with the load under consideration at room temperature, and $\min(U_{Batt,\ pred})$ being the minimum value of the voltage response over time,
   and the input variables being determined by means of an observation device (11), in particular a Kalman filter, which estimates the values of the rest voltage $U_R$, internal resistance $R_I$ and voltage drop $U_K$ on the basis of a measured battery voltage $U_{Batt}$, a measured battery temperature $T_{Batt}$ and a measured battery current $I_{Batt}$ using a model (2) which describes the battery.

2. Method according to the preceding claim, **characterized in that** the state of charge (SOC) of the battery is determined on the basis of the estimated rest voltage $U_R$.

3. Arrangement for estimation of the state of health (SOH) of a battery, in particular of a motor vehicle starter battery, having a predictor (1) for estimation of a battery voltage $U_{Batt,\ pred}$ which occurs in the event of a specific load current profile $I_{Batt,\ stim}$, in which case the rest voltage $U_R$, the internal resistance $R_I$ and the internal voltage drop $U_K$ caused by density differences in the battery acid as well as the specific load current profile $I_{Batt,\ stim}$ can be supplied as input variables to a model (2), which is used by the predictor (1), in order to describe the battery, and with an estimated battery voltage $U_{Batt,\ pred}$, which is obtained as a response from the model (2) and represents an estimate of the battery voltage relating to the load current profile $I_{Batt,\ stim}$ being compared with a limit voltage $U_{Batt,\ limit}$ in order to estimate the state of health (SOH) of the battery, in which case the input variables can be supplied to an observation device (11), in particular to a Kalman filter, by means of which the parameters used, comprising the rest voltage $U_R$, the internal resistance $R_I$ and the voltage drop $U_K$, can be estimated on the basis of a measured battery voltage $U_{Batt}$, a measured battery temperature $T_{Batt}$ and a measured battery current $I_{Batt}$, and **characterized by** the calculation of the state of health (SOH) of the battery using a formula in the form

$$SOH = (min(U_{Batt,\ pred,}\ (t))\ -\ U_{Batt,\ limit}) / (U_{Batt,\ norm}\ -\ U_{Batt,\ limit}),$$

with $U_{Batt,\ norm}$ being the terminal voltage which occurs when a new fully charged and stabilized battery is loaded with the load under consideration at room temperature, and $min(U_{Batt,\ pred})$ being the minimum value of the voltage response over time.

**Revendications**

1. Procédé pour évaluer l'état d'usure ou « State of Health SOH » d'une batterie comportant les étapes suivantes :

- détermination d'une tension au repos $U_R$, d'une résistance interne Ri et d'une chute de tension interne $U_K$ de la batterie due à des différences d'intensité dans l'électrolyte, en tant que grandeurs d'entrée d'un modèle,
- initialisation du modèle (2) décrivant la batterie pour évaluer l'état d'usure ou « State of Health SOH » avec les valeurs évaluées $U_R$, $R_I$ et $U_K$,
- stimulation du modèle initialisé avec une courbe de courant de charge donnée $I_{Batt,\ stirn}$, notamment d'une courbe de courant de charge simulée d'un dissipateur en liaison active avec la batterie, pour obtenir une réponse de tension $U_{Batt,\ präd}$ du modèle (2) représentant la tension de la batterie pour la courbe de courant de charge donnée,
- comparaison de la réponse de tension $U_{Batt,\ präd}$ du modèle (2) à une tension de batterie $U_{Batt,\ grenz}$ minimale prédéfinissable et

**caractérisé par**
l'évaluation de l'état d'usure ou « State of Health SOH » de la batterie suivant la formule :

$$SOH = (min(U_{Batt,\ präd}\ (t)) - U_{Batt,\ grenz}) / (U_{Batt,\ norm} - U_{Batt,\ grenz})$$

- la valeur minimale de la réponse de tension $min(U_{Batt,\ präd})$ dans le temps étant utilisée pour la comparaison de la réponse de tension $U_{Batt,\ präd}$ à la tension de batterie $U_{Batt,\ grenz}$ minimale prédéfinissable,
- $U_{Batt,\ norm}$ étant la tension aux bornes apparaissant lors de la contrainte d'une nouvelle batterie complètement chargée et équilibrée avec le dissipateur considéré à une température ambiante et $min(U_{Batt,\ präd})$ étant la valeur minimale sur le temps de la réponse de tension, et
- les grandeurs d'entrée étant déterminées à l'aide d'un dispositif d'observation (11), notamment d'un filtre Kalman, qui évalue les valeurs « Tension de repos » $U_R$, « Résistance interne » $R_I$ et « Chute de tension » $U_k$ sur la base d'une tension de batterie $U_{batt}$ mesurée, d'une température de batterie mesurée $T_{batt}$ et d'un courant de batterie mesuré $I_{batt}$ en utilisant un modèle (2) décrivant la batterie.

2. Procédé selon l'une des revendications précédentes
**caractérisé en ce que**
l'état de charge (SOC) de la batterie est déterminé sur la base de la tension de repos $U_R$ évaluée.

3. Dispositif d'évaluation d'une batterie, notamment d'une batterie de starter de véhicule automobile, doté d'un prédicteur (1) pour évaluer une tension de batterie $U_{Batt,\ ptäd}$ apparaissant pour une courbe de courant de charge donnée $I_{Batt,\ stirn}$, la tension de repos $U_r$, la résistance interne $R_I$ et la chute de tension interne $U_K$ due à des différences de densité dans l'électrolyte ainsi que la courbe de courant de charge donnée $I_{Batt,\ stirn}$ pouvant être amenés en tant que grandeurs d'entrée à l'un des modèles (2) utilisés par le prédicteur (1) pour représenter la batterie et une tension de batterie $U_{Batt,\ präd}$ évaluée, obtenue en tant que réponse du modèle (2) et représentant une évaluation de la tension de batterie par rapport à la courbe de courant de charge $I_{Batt,\ stirn}$, étant comparée à une tension limite $U_{Batt,\ grenz}$ pour évaluer l'état d'usure ou « State of Health SOH » de la batterie, les grandeurs d'entrée pouvant être amenées à un dispositif d'observation (11), notamment à un filtre Kalman, à l'aide duquel les paramètres utilisés « Tension de repos » $U_R$, « Résistance interne » $R_I$ et « Chute de tension » $U_K$ peuvent être évalués sur la base d'une tension de batterie mesurée $U_{batt}$, d'une température de batterie mesuré $T_{batt}$ et d'un courant de batterie mesuré $I_{batt}$ et
**caractérisé par**

le calcul de l'état d'usure ou « State of Health SOH » de la batterie en utilisant une formule de type

$$SOH = (min(U_{Batt, präd}(t)) - U_{Batt, grenz}) / (U_{Batt, norm} - U_{Batt, grenz}),$$

$U_{Batt, stirn}$ étant la tension aux bornes apparaissant lors de la contrainte d'une nouvelle batterie complètement chargée et compensée avec le dissipateur correspondant à température ambiante et $min(U_{Batt, präd})$ étant la valeur minimale sur le temps de la réponse de tension.

# FIG. 1

# FIG. 2

Messung von
$I_{Batt}$, $T_{Batt}$, $U_{Batt}$ ─── 201

↓

Abschätzen von
$U_R$, $I_R$ und $U_K$ ──→ Berechnung von SOC

202      203

↓

Abschätzen von
$U_{Batt, präd}$ a.d.
Grundlage von
$U_R$, $I_R$, $U_K$ und
$I_{Batt, stim}$ ─── 204

↓

Vergleich von $U_{Batt, präd}$
mit $U_{Batt, grenz}$ ─── 205

↓

Berechnung von
SOH ─── 206

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 471698 B1
- WO 9013828 A